# EUROPEAN PATENT SPECIFICATION

(11) **EP 3 871 072 B1**
(45) Date of publication and mention of the grant of the patent: **18.09.2024**
(21) Application number: 19794545.4
(22) Date of filing: 25.10.2019
(51) Int. Cl.: G06F 3/041, G06F 3/043

(54) **TOUCH DETECTION DEVICE**
BERÜHRUNGSEMPFINDLICHES GERÄT
DISPOSITIF DE DÉTECTION TACTILE

(30) Priority: 26.10.2018 CN 201811258140
(43) Date of publication of application: 01.09.2021
(73) Proprietor: Tyco Electronics (Shanghai) Co. Ltd., Shanghai (CN)
(72) Inventor: FENG, Yulin, Shanghai 200233 (CN); SONG, Yuming, Shanghai 200233 (CN); CHEN, Jin, Shanghai 200233 (CN); JIANG, Yifeng, Shanghai 200233 (CN)
(74) Representative: Grünecker Patent- und Rechtsanwälte PartG mbB
(86) International application number: PCT/EP2019/079211
(87) International publication number: WO 2020/084124

(56) References cited:
- WO-A1-2013/059488
- WO-A1-2017/028786
- WO-A2-2007/035896
- US-A1- 2006 144 154
- US-A1- 2006 232 558
- US-A1- 2010 253 648
- US-A1- 2014 327 626
- US-A1- 2015 035 759
- US-A1- 2015 346 903
- US-A1- 2016 299 621
- US-A1- 2019 102 001

## Description

### CROSS-REFERENCE TO RELATED APPLICATION

This application claims the benefit of Chinese Patent Application No. 201811258140.3 filed on October 26, 2018 in the State Intellectual Property Office of China,

### BACKGROUND OF THE INVENTION

### Field of the Invention

At least one embodiment of the present disclosure relates to a touch detection device, more particularly, relates to a touch detection device comprising a piezoelectric sensor.

### Description of the Related Art

In order to increase the convenience of controlling a device (for example, household appliances), touching or knocking a surface of the device by a finger is a visual and convenient Man-Machine Interaction. In the related art, a capacitance touch panel is usually used. However, if the touch area of the device is very large, such as when a whole door of a washing machine or a refrigerator is used as a touch input surface, the cost thereof becomes very high. At the same time, since the capacitance value is changed once the capacitance touch panel is touched, it cannot distinguish the touch force and the touch material. In other words, the capacitance touch panel will be triggered as long as it is touched, which will cause many false triggers. In some conditions, an input instruction to control the device is defined as an event of knocking or touching a surface of the device with a specific finger part, such as finger joint or fingertip. For example, an input instruction to open a light inside a refrigerator may be defined as a double-click event on the refrigerator door, an input instruction to open a dishwasher may be defined as a knock event on the dishwasher door, an input instruction to open a washer barrel lamp may be defined as a double-click event on the washer door, an input instruction to open a washer door may be defined as a triple-click event on the washer door.

In addition to the capacitance touch panel, in the related art, there are also some other solutions to control the device, for example, using a microphone to detect sound signals or using an acceleration sensor to detect vibration signals. In the solution of using the microphone to detect sound signals, it needs to form a closed voice cavity in the device, thereby the installation of the device is very troublesome and the cost thereof is high. In the solution of using the acceleration sensor to detect vibration signals, it needs to mount the accelerometer on the circuit board in a surface mounted manner, and it is needs to ensure the accelerometer to tightly contact a vibration surface of a vibration plate. When the vibration plate to be knocked is made of transparent material, such as, transparent glass, it is very difficult to hide the circuit board, causing great design challenges.

US 2015/035759 A1 relates to an electronic device including a touch-sensitive surface, for example a touch pad or touch screen. The user physically interacts with the touch-sensitive surface, producing touch events. The resulting interface actions taken depend at least in part on the touch type. The type of touch is determined in part based on vibro-acoustic data and touch data produced by the touch event.

WO 2007/035896 A2 relates to a sensor-based touchscreen assembly for use with a display panel, which is configured to determine a location on the display panel touched by a user. The sensor-based touchscreen assembly employs at least three sensors mounted on the display panel at different locations. The sensor-based touchscreen assembly further includes a controller coupled to the sensors. The controller is operable to determine a location on the display panel touched by a user by computing a time of difference of arrival of a signal (mechanical or sound wave) emitted from a touch to the sensors.

US 2006/232558 A1 relates to a virtual keyboard, which includes a virtual region, at least two vibration sensors, a storage unit and a processing unit. The processing unit determines a vibration source location of the vibration signal based on the output signals and locates a knocked virtual key by comparison of the vibration source location and the actual location recorded in the data, and generates a key signal according to the signification of the knocked key of the virtual keys.

US 2015/346903 A1 relates to a low power scan for device wake up and unlock. The low power scan can include one or more algorithms used to detect a sequence and/or one or more gestures to wake up a processor and unlock the device. In some examples, the microcontroller can determine if the sequence and gestures are due to water splashes, water film, and/or noise. In such examples, the microcontroller can reject the touch without waking up the processor, and further extending the battery life of the device.

US 2006/144154 A1 relates to a piezoelectric sensor including a transparent piezoelectric element having a piezoelectric property and a pair of transparent conductor film layers opposed to each other with the piezoelectric element therebetween. The transparent piezoelectric element and the transparent conductor film layers are formed between a pair of transparent substrates, opposed to each other, which serve as pressure transmission means.

US 2016/299621 A1 relates to an apparatus and method for recognizing a user input. The apparatus comprises a sensor configured to sense an acoustic wave signal generated by knocking a surface of a medium, an extractor configured to separate an initial pulse signal from the acoustic wave signal and extract signal characteristic of the separated initial pulse signal, and a controller configured to recognize a knocking gesture based on the signal characteristic extracted by the extractor and generate a corresponding control signal.

### SUMMARY OF THE INVENTION

The present disclosure has been made to overcome or alleviate at least one aspect of the above mentioned disadvantages.

According to an aspect of the present disclosure, there is provided a touch detection device according to claim 1.

According to another exemplary embodiment of the present disclosure, the first threshold range is 300µs~800µs, and the second threshold range is 300µs~1400µs.

According to another exemplary embodiment of the present disclosure, in a condition where the controller determines that the knock event is a correct human finger knock event, if the first DC voltage digital signal is detected by the controller only once, then the controller determines that the knock event is a single-click event.

According to another exemplary embodiment of the present disclosure, the touch panel is adapted to be mounted on a support body, the touch detection device further comprises an acoustic wave absorbing material adapted to be provided between the touch panel and the support body for acoustically isolating the touch panel from the support, so as to prevent sound waves generated on the support body from being transmitted to the touch panel.

According to another exemplary embodiment of the present disclosure, the support body is a housing, the touch panel is embedded in an opening of the support body, and the acoustic wave absorbing material is arranged at the periphery edge of the touch panel.

According to another exemplary embodiment of the present disclosure, the touch panel is supported on a surface of the support body, and the acoustic wave absorbing material is provided on the bottom of the touch panel.

According to another exemplary embodiment of the present disclosure, the touch panel is a circular panel, a square panel or a curved surface panel.

According to another exemplary embodiment of the present disclosure, the touch panel is made of glass, stainless steel or wood.

According to another exemplary embodiment of the present disclosure, the piezoelectric sensor is a piezoelectric thin film sensor or a piezoelectric ceramic sensor.

In the above various exemplary embodiments of the present disclosure, the touch detection device may conveniently and accurately identify whether the knock event applied on the touch panel is the correct human finger knock event. In addition, the configuration of the touch detection device is very simple, and the cost thereof is very low.

### BRIEF DESCRIPTION OF THE DRAWINGS

The above and other features of the present disclosure will become more apparent by describing in detail exemplary embodiments thereof with reference to the accompanying drawings, in which:
Fig.1 is an illustrative view of a touch detection device according to an embodiment of the present disclosure;
Fig.2 is an illustrative view of a touch detection device according to another embodiment of the present disclosure;
Fig.3 is an illustrative view of a touch detection device according to yet another embodiment of the present disclosure;
Fig.4 shows a functional block diagram of a control circuit board of a touch detection device according to an embodiment of the present disclosure;
Fig.5 is an illustrative view of a signal processing circuit of the control circuit board in Fig. 4;
Fig.6 shows an input signal from a piezoelectric sensor to the signal processing circuit and an output signal processed by the signal processing circuit; and
Fig.7 shows the flow chart of a controller of the control circuit board in Fig.4 to determine whether a knock event is a correct human finger knock event.

### DETAILED DESCRIPTION OF PREFERRED EMBODIMENTS OF THE

### IVENTION

Exemplary embodiments of the present disclosure will be described hereinafter in detail with reference to the attached drawings, wherein the like reference numerals refer to the like elements. The present disclosure may, however, be embodied in many different forms and should not be construed as being limited to the embodiment set forth herein; rather, these embodiments are provided so that the present disclosure will be thorough and complete, and will fully convey the concept of the disclosure to those skilled in the art.

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

According to a general concept of the present disclosure, there is provided a touch detection device, comprising: a touch panel; a piezoelectric sensor mounted on the touch panel and adapted to detect a knock or touching event applied to the touch panel; and a control circuit board electrically communicated with the piezoelectric sensor. The control circuit board comprising: a signal processing circuit adapted to process a detection signal output from the piezoelectric sensor; and a controller adapted to determine whether the knock event is a correct human finger knock event based on the processed detection signal.

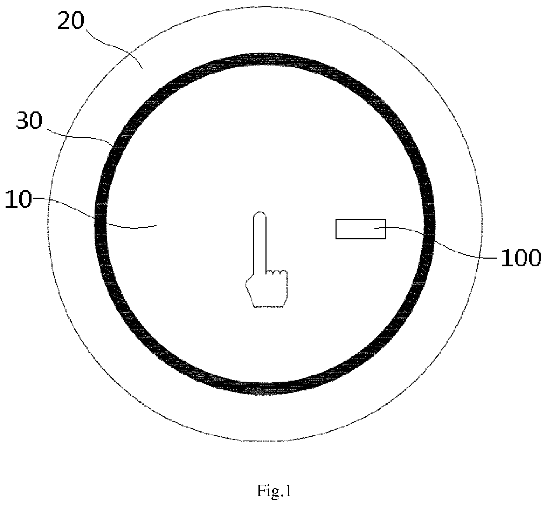

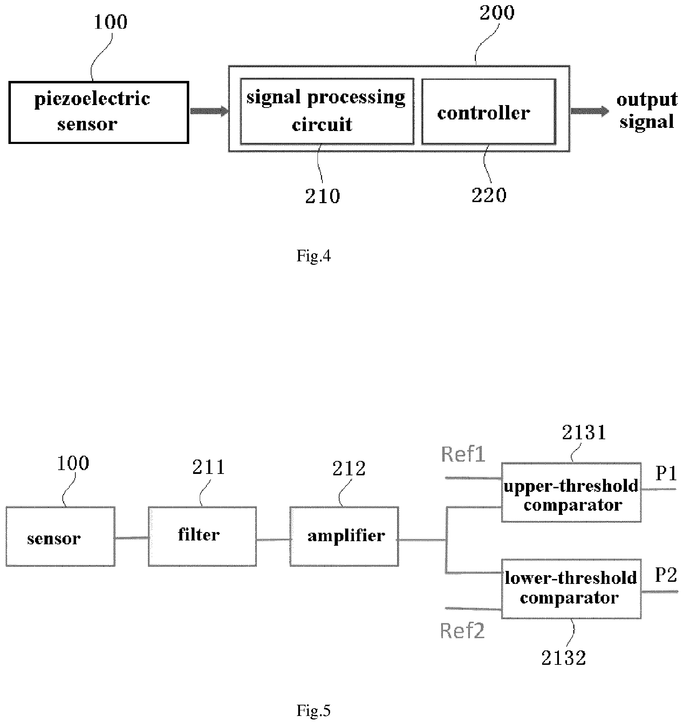

Fig.1 is an illustrative view of a touch detection device according to an embodiment of the present disclosure; Fig.4 shows a functional block diagram of a control circuit board of a touch detection device according to an embodiment of the present disclosure.

As shown in Figs.1 and 4, in an embodiment, the touch detection device mainly comprises a touch panel 10, a piezoelectric sensor 100, and a control circuit board 200. The piezoelectric sensor 100 is mounted on the touch panel 10 and adapted to detect a knock event applied to the touch panel 10. The control circuit board 200 is electrically communicated with the piezoelectric sensor 100.

As shown in Figs.1 and 4, in an embodiment, the piezoelectric sensor 100 is a piezoelectric thin film sensor. However, the present disclosure is not limited to this, the piezoelectric sensor may be any other type of piezoelectric sensor made of any suitable piezoelectric induction material. For example, the piezoelectric sensor 100 may be a piezoelectric ceramic sensor made of piezoelectric ceramic.

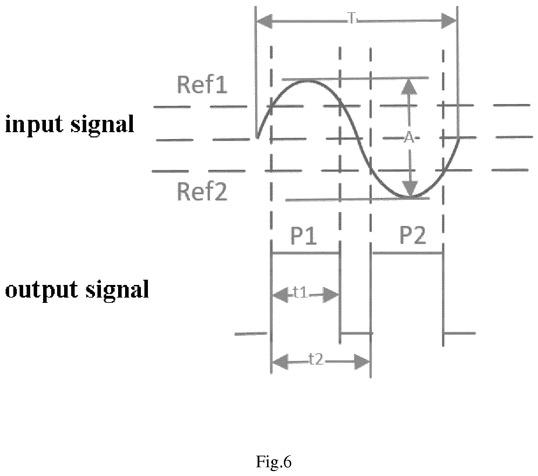

Fig.5 is an illustrative view of a signal processing circuit of the control circuit board in Fig. 4; Fig.6 shows an input signal from a piezoelectric sensor to the signal processing circuit and an output signal processed by the signal processing circuit.

As shown in Figs.4-6, in an embodiment, the control circuit board 200 may be connected to the piezoelectric sensor 100 by a wire. A hardware interface of the control circuit board 200 includes power supply, ground, and digital signal outputs.

As shown in Figs.4-6, in an embodiment, the control circuit board 200 mainly comprises a signal processing circuit 210 and a controller 220. The signal processing circuit 210 is configured to process a detection signal output from the piezoelectric sensor 100. The controller 220 is adapted to determine whether the knock event is a correct human finger knock event based on the processed detection signal.

As shown in Figs.4-6, in an embodiment, the signal processing circuit 210 comprises a filter 211, an amplifier 212, and a comparator 2131, 2132. The filter 211 is configured to filter out noise signals that are not satisfied with a predetermined condition from the detection signal. For example, the filter 211 may filter out high-frequency vibration signals with a frequency higher than 2 KHz, because finger knocking frequency is usually below 2 KHz.

As shown in Figs.4-6, in an embodiment, the amplifier 212 is configured to amplify the filtered detection signal to a desired range. The comparator 2131, 2132 comprises an upper-threshold comparator 2131 with a predetermined upper-threshold voltage Ref1 and a lower-threshold comparator 2132 with a predetermined lower-threshold voltage Ref2. The upper-threshold comparator 2131 is configured to process the amplified detection signal into a first DC voltage digital signal P1, and the lower-threshold comparator 2132 is configured to process the amplified detection signal into a second DC voltage digital signal P2.

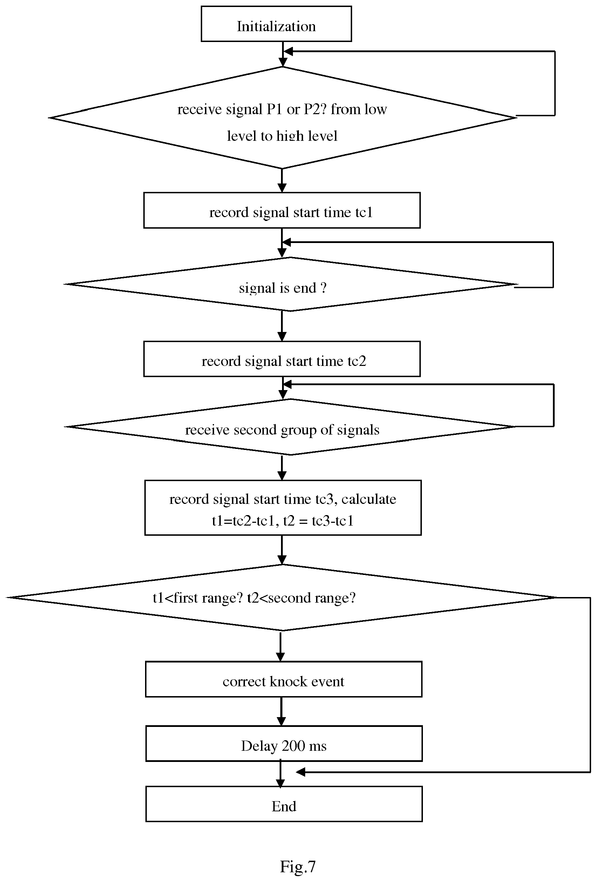

Fig.7 shows the flow chart of a controller of the control circuit board in Fig.4 to determine whether a knock event is a correct human finger knock event.

As shown in Figs.4-7, in an embodiment, the controller 220 is adapted to calculate a first time difference t1 between an end time tc2 and a start time of the detected first DC voltage digital signal P1, calculate a second time difference t2 between the start time of the detected first DC voltage digital signal P1 and a start time of the second DC voltage digital signal P2 detected just after the detected first DC voltage digital signal P1, and determine whether the knock event is a correct human finger knock event based on the calculated first time difference t1 and the calculated second time difference t2.

As shown in Figs.4-7, in an embodiment, if the calculated first time difference t1 is within a first threshold range and the calculated second time difference t2 is within a second threshold range, then the controller 220 determines that the knock event is a correct human finger knock event.

As shown in Figs.4-7, in an embodiment, if the calculated first time difference t1 exceeds the first threshold range or the calculated second time difference t2 exceeds the second threshold range, then the controller 220 determines that the knock event is not a correct human finger knock event.

As shown in Figs.4-7, in an embodiment, the first threshold range is 300µs~800µs, and the second threshold range is 300µs~1400µs.

As shown in Figs.4-7, in an embodiment, in a condition where the controller 220 determines that the knock event is a correct human finger knock event, if the first DC voltage digital signal P1 is detected by the controller 220 only once, then the controller 220 determines that the knock event is a single-click event.

As shown in Figs.4-7, in an embodiment, in a condition where the controller 220 determines that the knock event is a correct human finger knock event, if the first DC voltage digital signal P1 is detected by the controller 220 twice and a time interval between two adjacent first DC voltage digital signals P1 detected by the controller 220 is within a third threshold range, the controller 220 determines that the knock event is a double-click event.

As shown in Figs.4-7, in an embodiment, the third threshold range is 200ms~500ms, because the time interval of double-click of human finger is within a range of 200ms~1s.

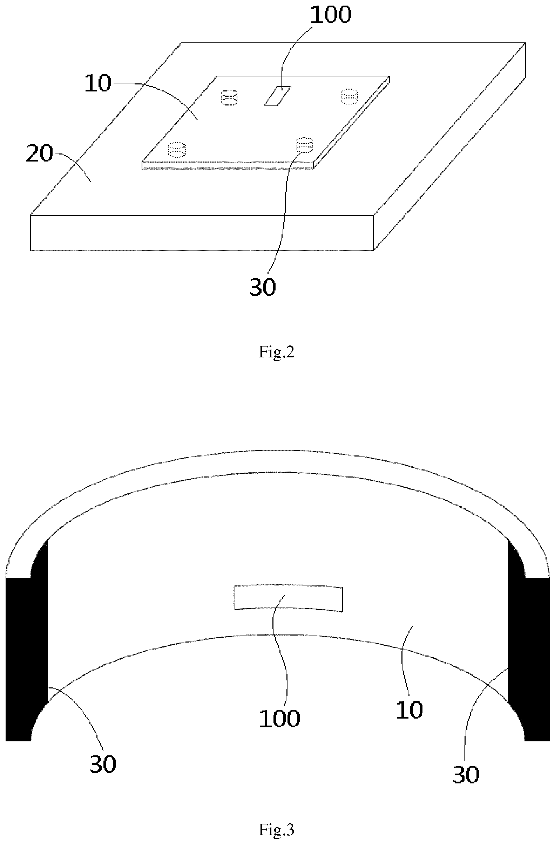

Fig.2 is an illustrative view of a touch detection device according to another embodiment of the present disclosure; Fig.3 is an illustrative view of a touch detection device according to yet another embodiment of the present disclosure.

As shown in Figs. 1-3, in an embodiment, the touch panel 10 is adapted to be mounted on a support body 20. The touch detection device further comprises an acoustic wave absorbing material 30 provided between the touch panel 10 and the support body 20. The acoustic wave absorbing material 30 is configured to acoustically isolate the touch panel 10 from the support 20, so as to prevent sound waves generated on the support body 20 from being transmitted to the touch panel 10.

As shown in Figs. 1-3, in an embodiment, the support body 20 is formed as a housing. The touch panel 10 is embedded in an opening of the support body 20, and the acoustic wave absorbing material 30 is arranged at the periphery edge of the touch panel 10.

As shown in Fig.2, in an embodiment, the touch panel 10 is supported on a surface of the support body 20, and the acoustic wave absorbing material 30 is provided on the bottom of the touch panel 10.

As shown in Figs. 1-3, in an embodiment, the touch panel 10 may comprise a circular panel, a square panel or a curved surface panel.

As shown in Figs. 1-3, in an embodiment, the touch panel 10 may be made of glass, stainless steel or wood.

The present application provides a sensor and a panel adapted to detect knock signals based on piezoelectric material such as piezoelectric thin film and piezoelectric ceramic. A piece of piezoelectric material is mounted on a rigid panel. The shape of the panel may have a flat surface or any arbitrary three-dimensional surface. Sound absorbing material such as sound-absorbing foam or rubber is provided around the rigid panel to isolate the sound. When the finger knocks the panel, the sound wave (mechanical wave) generated by knocking is propagated along the hard panel to the position where the piezoelectric material is located. The piezoelectric material produces piezoelectric effect due to vibration, and generates charges on the upper and lower surface of the piezoelectric material. Thereby, the piezoelectric material produces a voltage signal, and the generated voltage signal is amplified and filtered by a corresponding circuit, and then is processed by a specific algorithm to obtain a desired signal. When a region outside the panel is knocked by the finger, the mechanical vibration of the panel is not transmitted to the location of the piezoelectric material because the sound-absorbing material prevents the mechanical vibration from being transmitted to the piezoelectric material, so the false trigger may be avoided.

In the present application, the piezoelectric sensor may be easily and directly mounted on a hard surface such as glass, mirror, stainless steel, and wood by surface mount Technology (SMT). Thereby, it has great cost advantages. In addition, it has no restrictions on the shape and size of the panel, and the piezoelectric sensor may be mounted on any part of the panel, and has fewer restrictions and challenges on the design of the device, for example, household appliances.

In the present application, the knock or touching signal transmitted by the piezoelectric thin film sensor is processed by a hardware circuit into a digital signal related to the knock or touching force and the knock or touching frequency, and then the knock or touching signal is filtered through software algorithm to determine whether it is a human finger knock or touching event or a double-click event. Thereby, it may be very intelligent to complete the detection of human knock or touching, and may be used for different user experiences of household appliances.

It should be appreciated for those skilled in this art that the above embodiments are intended to be illustrated, and not restrictive.

As used herein, an element recited in the singular and preceded with the word "a" or "an" should be understood as not excluding plural of said elements or steps, unless such exclusion is explicitly stated. Furthermore, references to "one embodiment" of the present disclosure are not intended to be interpreted as excluding the existence of additional embodiments that also incorporate the recited features. Moreover, unless explicitly stated to the contrary, embodiments "comprising" or "having" an element or a plurality of elements having a particular property may include additional such elements not having that property.

## Claims

1. A touch detection device, comprising:
a touch panel (10);
a piezoelectric sensor (100) mounted on the touch panel (10) and adapted to detect a knock event applied to the touch panel (10); and
a control circuit board (200) electrically communicated with the piezoelectric sensor (100), and comprising:
a signal processing circuit (210) adapted to process a detection signal output from the piezoelectric sensor (100); and
a controller (220) adapted to determine whether the knock event is a correct human finger knock event based on the processed detection signal,
wherein the signal processing circuit (210) comprises:
a filter (211) configured to filter out noise signals that are not satisfied with a predetermined condition from the detection signal;
an amplifier (212) configured to amplify the filtered detection signal to a desired range; and
a comparator (2131, 2132) comprising an upper-threshold comparator (2131) with a predetermined upper-threshold voltage (Ref1) and a lower-threshold comparator (2132) with a predetermined lower-threshold voltage (Ref2) to process the amplified detection signal into a first DC voltage digital signal (P1) and a second DC voltage digital signal (P2), and
wherein the controller (220) is adapted to
- calculate a first time difference (t1) between an end time (tc2) and a start time (tc1) of the detected first DC voltage digital signal (P1),
- calculate a second time difference (t2) between the start time (tc1) of the detected first DC voltage digital signal (P1) and a start time (tc3) of the second DC voltage digital signal (P2) detected just after the detected first DC voltage digital signal (P1), and
- determine whether the knock event is a correct human finger knock event based on the calculated first time difference (t1) and the calculated second time difference (t2),
wherein if the calculated first time difference (t1) is within a first threshold range and the calculated second time difference (t2) is within a second threshold range, then the controller (220) determines that the knock event is a correct human finger knock event,
wherein if the calculated first time difference (t1) exceeds the first threshold range or the calculated second time difference (t2) exceeds the second threshold range, then the controller (220) determines that the knock event is not a correct human finger knock event,
wherein in a condition where the controller (220) determines that the knock event is a correct human finger knock event, if the first DC voltage digital signal (P1) is detected by the controller (220) twice and a time interval between two adjacent first DC voltage digital signals (P1) detected by the controller (220) is within a third threshold range, the controller (220) determines that the knock event is a double-click event,
wherein the third threshold range is 200ms~500ms.

2. The touch detection device according to claim 1,
wherein the first threshold range is 300µs~800µs, and the second threshold range is 300 µs~1400µs.

3. The touch detection device according to claim 1 or 2,
wherein in a condition where the controller (220) determines that the knock event is a correct human finger knock event, if the first DC voltage digital signal (P1) is detected by the controller (220) only once, then the controller (220) determines that the knock event is a single-click event.

4. The touch detection device according to any one of claims 1-3,
wherein the touch panel (10) is adapted to be mounted on a support body (20), the touch detection device further comprises an acoustic wave absorbing material (30) adapted to be provided between the touch panel (10) and the support body (20) for acoustically isolating the touch panel (10) from the support (20), so as to prevent sound waves generated on the support body (20) from being transmitted to the touch panel (10).

5. The touch detection device according to claim 4,
wherein the support body (20) is formed as a housing, the touch panel (10) is embedded in an opening of the support body (20), and the acoustic wave absorbing material (30) is arranged at the periphery edge of the touch panel (10).

6. The touch detection device according to claim 4 or 5,
wherein the touch panel (10) is supported on a surface of the support body (20), and the acoustic wave absorbing material (30) is provided on the bottom of the touch panel (10).

7. The touch detection device according to any one of claims 1-6,
wherein the touch panel (10) comprises a circular panel, a square panel or a curved surface panel.

8. The touch detection device according to any one of claims 1-7,
wherein the touch panel (10) is made of glass, stainless steel or wood.

9. The touch detection device according to any one of claims 1-8,
wherein the piezoelectric sensor (100) comprises a piezoelectric thin film sensor or a piezoelectric ceramic sensor.

## Patentansprüche

1. Eine Berührungserkennungsvorrichtung, aufweisend:
ein Berührungsfeld (10);
einen piezoelektrischen Sensor (100), der auf dem Berührungsfeld (10) angebracht ist und geeignet ist, ein auf das Berührungsfeld (10) ausgeübtes Klopfereignis zu erfassen; und
eine Steuerschaltungsplatine (200), die elektrisch mit dem piezoelektrischen Sensor (100) verbunden ist und Folgendes umfasst:
eine Signalverarbeitungsschaltung (210), die dazu ausgelegt ist, ein von dem piezoelektrischen Sensor (100) ausgegebenes Erfassungssignal zu verarbeiten; und
eine Steuereinheit (220), die dazu ausgelegt ist, auf der Grundlage des verarbeiteten Erfassungssignals zu bestimmen, ob das Klopfereignis ein korrektes menschliches Fingerklopfereignis ist,
wobei die Signalverarbeitungsschaltung (210) umfasst:
einen Filter (211), der so konfiguriert ist, dass er Rauschsignale, die eine vorbestimmte Bedingung nicht erfüllen, aus dem Erfassungssignal herausfiltert;
einen Verstärker (212), der konfiguriert ist, um das gefilterte Erfassungssignal auf einen gewünschten Bereich zu verstärken; und
einen Komparator (2131, 2132), der einen Oberschwellenkomparator (2131) mit einer vorbestimmten Oberschwellenspannung (Ref1) und einen Unterschwellenkomparator (2132) mit einer vorbestimmten Unterschwellenspannung (Ref2) umfasst, um das verstärkte Erfassungssignal zu einem ersten digitalen Gleichspannungssignal (P1) und einem zweiten digitalen Gleichspannungssignal (P2) zu verarbeiten, und
wobei die Steuerung (220) dazu ausgelegt ist
- eine erste Zeitdifferenz (t1) zwischen einer Endzeit (tc2) und einer Startzeit (tc1) des erfassten ersten digitalen Gleichspannungssignals (P1) zu berechnen,
- Berechnen einer zweiten Zeitdifferenz (t2) zwischen der Startzeit (tc1) des erfassten ersten digitalen Gleichspannungssignals (P1) und einer Startzeit (tc3) des zweiten digitalen Gleichspannungssignals (P2), das unmittelbar nach dem erfassten ersten digitalen Gleichspannungssignal (P1) erfasst wird, und
- Bestimmen, ob das Klopfereignis ein korrektes menschliches Fingerklopfereignis ist, basierend auf der berechneten ersten Zeitdifferenz (t1) und der berechneten zweiten Zeitdifferenz (t2),
wobei, wenn die berechnete erste Zeitdifferenz (t1) innerhalb eines ersten Schwellenwertbereichs liegt und die berechnete zweite Zeitdifferenz (t2) innerhalb eines zweiten Schwellenwertbereichs liegt, die Steuereinheit (220) bestimmt, dass das Klopfereignis ein korrektes menschliches Fingerklopfereignis ist,
wobei, wenn die berechnete erste Zeitdifferenz (t1) den ersten Schwellenwertbereich überschreitet oder die berechnete zweite Zeitdifferenz (t2) den zweiten Schwellenwertbereich überschreitet, die Steuereinheit (220) dann bestimmt, dass das Klopfereignis kein korrektes menschliches Fingerklopfereignis ist,
wobei in einem Zustand, in dem die Steuereinheit (220) bestimmt, dass das Klopfereignis ein korrektes menschliches Fingerklopfereignis ist, die Steuereinheit (220) bestimmt, dass das Klopfereignis ein Doppelklickereignis ist, wenn das erste digitale Gleichspannungssignal (P1) von der Steuereinheit (220) zweimal detektiert wird und ein Zeitintervall zwischen zwei benachbarten ersten digitalen Gleichspannungssignalen (P1), die von der Steuereinheit (220) detektiert werden, innerhalb eines dritten Schwellenbereichs liegt,
wobei der dritte Schwellenwertbereich 200ms~500ms beträgt.

2. Die Berührungserkennungsvorrichtung nach Anspruch 1,
wobei der erste Schwellenwertbereich 300µs~800µs und der zweite Schwellenwertbereich 300µs~1400µs beträgt.

3. Die Berührungserkennungsvorrichtung nach Anspruch 1 oder 2,
wobei in einem Zustand, in dem die Steuerung (220) bestimmt, dass das Klopfereignis ein korrektes menschliches Fingerklopfereignis ist, wenn das erste digitale Gleichspannungssignal (P1) von der Steuerung (220) nur einmal erfasst wird, die Steuerung (220) bestimmt, dass das Klopfereignis ein Einzelklickereignis ist.

4. Die Berührungserkennungsvorrichtung nach einem der Ansprüche 1-3,
wobei das Berührungsfeld (10) zur Anbringung an einem Trägerkörper (20) geeignet ist, wobei die Berührungserfassungsvorrichtung ferner ein schallwellenabsorbierendes Material (30) umfasst, das zur Bereitstellung zwischen dem Berührungsfeld (10) und dem Trägerkörper (20) geeignet ist, um das Berührungsfeld (10) von dem Träger (20) akustisch zu isolieren, um zu verhindern, dass auf dem Trägerkörper (20) erzeugte Schallwellen auf das Berührungsfeld (10) übertragen werden.

5. Die Berührungserkennungsvorrichtung nach Anspruch 4,
wobei der Trägerkörper (20) als ein Gehäuse ausgebildet ist, das Berührungsfeld (10) in eine Öffnung des Trägerkörpers (20) eingebettet ist und das schallwellenabsorbierende Material (30) an der Umfangskante des Berührungsfeldes (10) angeordnet ist.

6. Die Berührungserkennungsvorrichtung nach Anspruch 4 oder 5,
wobei das Berührungsfeld (10) auf einer Oberfläche des Trägerkörpers (20) getragen wird und das schallwellenabsorbierende Material (30) auf der Unterseite des Berührungsfeldes (10) vorgesehen ist.

7. Die Berührungserkennungsvorrichtung nach einem der Ansprüche 1 bis 6,
wobei das Berührungsfeld (10) ein rundes Feld, ein quadratisches Feld oder ein Feld mit gekrümmter Oberfläche umfasst.

8. Die Berührungserkennungsvorrichtung nach einem der Ansprüche 1-7,
wobei das Berührungsfeld (10) aus Glas, rostfreiem Stahl oder Holz hergestellt ist.

9. Die Berührungserkennungsvorrichtung nach einem der Ansprüche 1-8,
wobei der piezoelektrische Sensor (100) einen piezoelektrischen Dünnschichtsensor oder einen piezoelektrischen Keramiksensor umfasst.

## Revendications

1. Dispositif de détection tactile comprenant :
un écran tactile (10) ;
un capteur piézoélectrique (100) monté sur l'écran tactile (10) et conçu pour détecter une frappe appliquée à l'écran tactile (10) ; et
une carte de circuit de commande (200) en communication électrique avec le capteur piézoélectrique (100), et comprenant :
un circuit de traitement des signaux (210) conçu pour traiter un signal de détection émis par le capteur piézoélectrique (100) ; et
un dispositif de commande (220) capable de déterminer si l'instant de frappe est un instant de frappe correct produit par un doigt humain sur la base du signal de détection traité,
dans lequel le circuit de traitement des signaux (210) comprend :
un filtre (211) configuré pour filtrer les signaux de bruit qui ne satisfont pas à une condition prédéterminée du signal de détection ;
un amplificateur (212) configuré pour amplifier le signal de détection filtré dans une plage souhaitée ; et
un comparateur (2131, 2132) comprenant un comparateur à seuil supérieur (2131) avec une tension de seuil supérieur prédéterminée (Ref1) et un comparateur à seuil inférieur (2132) avec une tension de seuil inférieur prédéterminée (Ref2) pour traiter le signal de détection amplifié en un premier signal numérique de tension continue (P1) et un second signal numérique de tension continue (P2), et
dans lequel le dispositif de commande (220) est conçu pour
- calculer une première différence de temps (t1) entre une heure de fin (tc2) et une heure de début (tc1) du premier signal numérique de tension continue détecté (P1),
- calculer une deuxième différence de temps (t2) entre l'heure de début (tc1) du premier signal numérique de tension continue détecté (P1) et l'heure de début (tc3) du deuxième signal numérique de tension continue (P2) détecté juste après le premier signal numérique de tension continue détecté (P1), et
- déterminer si l'instant de frappe est un instant de frappe correct produit par un doigt humain sur la base de la première différence de temps calculée (t1) et de la seconde différence de temps calculée (t2),
si la première différence de temps calculée (t1) se situe dans une première plage de seuils et que la deuxième différence de temps calculée (t2) se situe dans une deuxième plage de seuils, le dispositif de commande (220) détermine que l'instant de frappe est un instant de frappe correct produit par un doigt humain,
si la première différence de temps calculée (t1) dépasse le premier seuil ou si la deuxième différence de temps calculée (t2) dépasse le deuxième seuil, le dispositif de commande (220) détermine que l'instant de frappe n'est pas un instant de frappe correct produit par un doigt humain,
dans lequel, lorsque le dispositif de commande (220) détermine que l'instant de frappe est un instant de frappe correct produit par un doigt humain, si le premier signal numérique de tension continue (P1) est détecté deux fois par le dispositif de commande (220) et que l'intervalle de temps entre deux premiers signaux numériques de tension continue adjacents (P1) détectés par le dispositif de commande (220) se situe dans une troisième plage de seuils, le dispositif de commande (220) détermine que l'instant de frappe est un instant de double-clic,
dans laquelle la troisième plage de seuils est comprise entre 200 ms et 500 ms.

2. Dispositif de détection tactile selon la revendication 1,
où la première plage de seuils est de 300µs~800µs, et la seconde plage de seuils est de 300µs~1400µs.

3. Dispositif de détection tactile selon les revendications 1 ou 2,
où le dispositif de commande (220) détermine que la frappe est une frappe correcte produite par un doigt humain, si le premier signal numérique de tension continue (P1) n'est détecté par le dispositif de commande (220) qu'une seule fois, le dispositif de commande (220) détermine que le frappe est un instant à un seul clic.

4. Dispositif de détection tactile selon l'une des revendications 1 à 3,
dans lequel l'écran tactile (10) est conçu pour être monté sur un support (20), le dispositif de détection tactile comprend en outre un matériau absorbant les ondes acoustiques (30) conçu pour être placé entre l'écran tactile (10) et le support (20) afin d'isoler acoustiquement l'écran tactile (10) du support (20), de manière à empêcher les ondes sonores générées sur le support (20) d'être transmises à l'écran tactile (10).

5. Dispositif de détection tactile selon la revendication 4,
dans lequel le corps de support (20) est en forme de boîtier, l'écran tactile (10) est encastré dans une ouverture du corps de support (20), et le matériau absorbant les ondes acoustiques (30) est disposé sur le bord périphérique de l'écran tactile (10).

6. Dispositif de détection tactile selon les revendications 4 ou 5,
dans lequel l'écran tactile (10) est soutenu sur une surface du corps de support (20), et le matériau absorbant les ondes acoustiques (30) est placé sur le fond de l'écran tactile (10).

7. Dispositif de détection tactile selon l'une des revendications 1 à 6,
dans lequel le panneau tactile (10) comprend un panneau circulaire, un panneau carré ou un panneau à surface incurvée.

8. Dispositif de détection tactile selon l'une des revendications 1 à 7,
dans lequel l'écran tactile (10) est en verre, en acier inoxydable ou en bois.

9. Dispositif de détection tactile selon l'une des revendications 1 à 8,
dans lequel le capteur piézoélectrique (100) comprend un capteur piézoélectrique à couche mince ou un capteur piézoélectrique en céramique.
